(19) Europäisches Patentamt

European Patent Office

Office européen des brevets

(11) EP 2 264 561 A1

(12) EUROPEAN PATENT APPLICATION

(43) Date of publication:
22.12.2010 Bulletin 2010/51

(51) Int Cl.:
$G05F\ 1/565^{(2006.01)}$

(21) Application number: 09251598.0

(22) Date of filing: 18.06.2009

(84) Designated Contracting States:
AT BE BG CH CY CZ DE DK EE ES FI FR GB GR
HR HU IE IS IT LI LT LU LV MC MK MT NL NO PL
PT RO SE SI SK TR
Designated Extension States:
AL BA RS

(71) Applicant: NXP B.V.
5656 AG Eindhoven (NL)

(72) Inventor: Nowak, Katarzyna
5656 AG Eindhoven (NL)

(74) Representative: Williamson, Paul Lewis
NXP Semiconductors
IP Department
Betchworth House
57-65 Station Road
Redhill
Surrey RH1 1DL (GB)

(54) **Voltage regulator**

(57)     A voltage regulator (400) comprising a controllable component (402) connected between the input and output of the voltage regulator. The controllable element (402) is configured to connect and disconnect the output of the voltage regulator (400) to the input of the voltage regulator (400) in accordance with a received control signal (422).

## Figure 4

EP 2 264 561 A1

## Description

The present disclosure relates to the field of voltage regulators, devices comprising voltage regulators, and methods of operating voltage regulators.

It is known to use low drop-out voltage regulators (LDOs) to provide a required voltage level for a specific application. It is also known to integrate such low drop-out voltage regulators into an integrated circuit (IC) to provide a desired voltage level for specific components within the integrated circuit.

Systems-on-chip (SoC) are known to be implemented with multiple voltage islands. A typical voltage island comprises a set of analogue or digital components/blocks that require the same supply voltage level. The division of a complex system into voltage islands with independent supply voltages allow power consumption reduction of the system as a whole. This is because the supply voltage of each voltage island can be optimised and regulated individually based on the requirements of their components/blocks.

It is known to integrate power management (PM) functionality into the systems-on-chip in order to reduce the cost and improve the performance of the systems-on-chip.

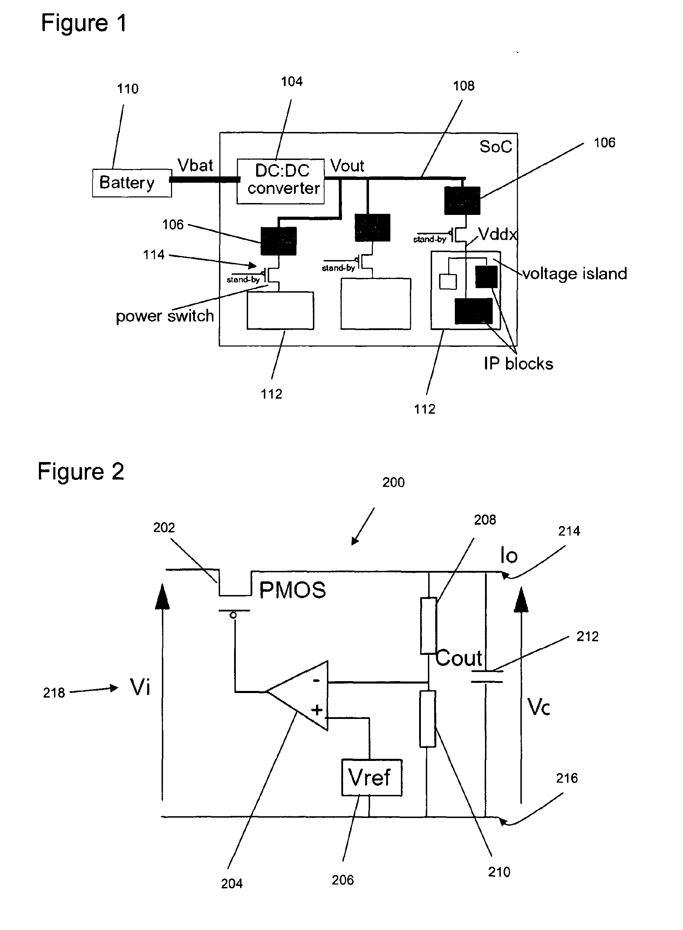

A typical SoC with an integrated power management block and multiple voltage islands is shown as Figure 1, and includes a DC to DC converter 104 and multiple low drop-out voltage regulators (LDOs) 106. In such a system, the DC to DC converter 104 generates an intermediate level of the voltage Vout 108 derived from the voltage supplied by battery 110. The LDOs 106 are then configured to convert the intermediate voltage Vout 108 to the specific voltage levels that are required by the different voltage islands 112.

As known in the art, a power switch 114 is located between each LDO 106 and each voltage island 112 in order to operably disconnect the voltage island 112 from its power supply (as provided by the LDO 106) when the blocks of the voltage island 112 are to enter a standby mode. In this way, a reduction of the power consumption of the chip as a whole can be reduced as unnecessary current drawn by a voltage island 112 when in a standby mode can be reduced/prevented. Reduction in current can be especially relevant in deep-submicron process technologies in which the leakage (off-state, stand-by) current can be considerable due to the reduced threshold voltage of MOS devices. The power switch 114 is typically implemented as a very large transistor (for example a PMOS transistor with a channel width of a few thousand micrometers) in order to deal with a large current (typically in the range of hundreds of milliamps) that an LDO 106 typically supplies to its voltage island 112, and to guarantee a small voltage drop across the transistor when the current flows through it.

Figure 2 illustrates a prior art low drop-out voltage regulator (LDO) 200. The LDO 200 comprises a comparator amplifier 204 having a positive and a negative input. The positive input is connected to a constant voltage reference source 206, and the negative input of the comparator 204 is connected to the junction between two resistors 208, 210 in series between the output pins 214, 216 of the LDO 200. It will be appreciated that the voltage provided to the negative input of the comparator 204 represents a proportion of the output voltage of the LDO 200 as defined by the ratio of the values of the two resistors 208, 210.

The output of the comparator 204 is provided to the gate of a PMOS field effect transistor (FET) 202 which plays a role of a series-pass element. The source of the PMOS FET 202 is connected to the input voltage 218, and the drain of the PMOS FET 202 is connected to the positive output 214 of the LDO 200.

An output capacitor Cout 212 is also connected between the output pins 214, 216 of the LDO 200.

The listing or discussion of a prior-published document or any background in the specification should not necessarily be taken as an acknowledgement that the document or background is part of the state of the art or is common general knowledge.

According to a first aspect of the invention, there is provided voltage regulator comprising:

a controllable component connected between the input and output of the voltage regulator,

wherein the controllable component is configured to connect and disconnect the output of the voltage regulator to the input of the voltage regulator in accordance with a received control signal.

Use of the controllable component/element in this way can reduce the silicon area/realestate that is required to provide a controllable voltage regulator. In addition, some embodiments described herein can also provide more efficient operation of the voltage regulator.

The control signal may be representative of a standby state of components that are provided with voltage by the voltage regulator. In some embodiments, the control signal may be referred to as a standby signal. The components that are provided with voltage by the voltage regulator may comprise a voltage island.

The controllable component may be a transistor (402). In this way, an existing transistor of a voltage regulator, such as a low dropout voltage regulator, can be used to connect and disconnect the voltage regulator to a voltage island or any other load without the requirement of a separate power switch transistor. This can reduce the silicon area/realestate that is required to provide a controllable voltage regulator. In addition, some embodiments described herein can also provide more efficient operation of the voltage regulator.

The controllable component may be configured to break a control loop of the voltage regulator when disconnecting the output of the voltage regulator from the input of the voltage regulator.

The voltage regulator may comprise an amplifier. The output of the amplifier may be connectable and disconnectable to a control terminal of the transistor in accordance with the received control signal. Depending upon the type of transistor that is being used, the control terminal of the transistor may be the gate or base terminal.

The amplifier may be an operational amplifier. When an operational amplifier is used with one or more embodiments of the invention, it may be referred to as an error amplifier as it can be used as part of a negative feedback loop.

The voltage regulator may further comprise a multiplexer configured to connect either the output of the amplifier or a second control signal to the transistor in accordance with the standby signal. The second control signal that is connectable to the transistor may be the same signal as the control signal that is representative of a standby state of components that are provided with voltage by the voltage regulator, or may be a different signal. The multiplexer can be used to either connect the output of the amplifier to the transistor such that the voltage regulator operates in its "normal" way, or connect the second control signal to the transistor in order to switch off the transistor and therefore switch off the voltage regulator. The multiplexer can be configured to connect the output of the amplifier to the transistor when the standby signal comprises signalling that represents the fact that a voltage island is not in a standby state. The multiplexer can be configured to connect the second control signal to the transistor when the standby signal comprises signalling that represents the fact that a voltage island is in a standby state.

The amplifier may have a positive input and a negative input, and may be a comparator built from an operational amplifier. The positive input may be connected to a constant voltage reference source, and the negative input may be connected to a proportion of the output voltage as determined by the values of a resistor pair.

The voltage regulator may further comprise a capacitor connected across the output of the voltage regulator. The output current of the capacitor may be provided to a watchdog component associated with a voltage island.

The capacitor may be configured to discharge when the output of the amplifier is not connected to the transistor such that the capacitor provides an output current when the voltage regulator is switched off - that is the load (a voltage island) is in a standby mode. The output current can be used by a watchdog component associated with a voltage island/ load supplied by the voltage regulator, and this can avoid the need for a dedicated voltage supply for the watchdog component.

Supplying the watchdog component with current in this way can provide an efficient voltage regulator and/or integrated circuit (IC) on which the voltage regulator is located.

The output of the amplifier may be operably connectable to the transistor if the standby signal is representative of a standby state and the capacitor is discharged. For example, if the capacitor is completely or nearly completely discharged. In this way, the transistor can be temporarily switched on to recharge/boost the capacitor when the charge of the capacitor is running low. This can be used to maintain an output current of the voltage regulator for a watchdog component even when a voltage island is placed in standby mode for a long period of time. Operating a capacitor in this way may be more efficient than providing a watchdog component with a constant voltage source irrespective of the state of a voltage island with which it is associated.

The voltage regulator may further comprise a "reverse body-bias voltage generation" module configured to: when the standby signal is high, provide the bulk terminal of the transistor with a voltage that is higher than the input voltage in order to reduce the leakage current of the transistor; and

when the standby signal is low, connect the bulk terminal of the transistor to the input voltage.

In this way, the leakage current of the transistor can be reduced as the threshold voltage of the transistor is increased when the standby signal is representative of a standby state.

The "reverse body-bias voltage generation" module may comprise a voltage multiplier configured to generate an output voltage that is higher than its input voltage, or may comprise any other component(s) that can provide the required voltage level.

There may be provided an integrated circuit comprising a voltage regulator as described herein.

There may be provided an electronic device comprising a voltage regulator as described herein, or an integrated circuit as described herein.

The electronic device may be one of: a portable electronic device, a mobile telephone, a personal digital assistant, and an MP3 player. In some embodiments, the electronic device may be any battery operated electronic device.

According to a further aspect of the invention, there is provided a method of operating a voltage regulator, the voltage regulator comprising:

a controllable element connected between the input and output of the voltage regulator;

the method comprising:

receiving a control signal; and
automatically connecting or disconnecting the output of the voltage regulator to the input of the voltage regulator in accordance with the received control signal.

There may also be provided a method of operating a voltage regulator, the voltage regulator comprising:

an amplifier; and
a transistor;
the method comprising:
receiving a standby signal; and
automatically connecting or disconnecting the output of the amplifier to the (gate of the) transistor in accordance with a received standby signal.

A description is now given, by way of example only, with reference to the accompanying drawings, in which:

Figure 1 illustrates a prior art systems-on-chip;
Figure 2 illustrates a prior art low drop-out voltage regulator;
Figure 3a illustrates a prior art systems-on-chip system for placing a voltage island in standby mode;
Figure 3b illustrates a systems-on-chip system for placing a voltage island in standby mode according to an embodiment of the invention;
Figure 4 illustrates a voltage regulator according to an embodiment of the invention; and
Figure 5 illustrates a reverse body-bias voltage generator circuit according to an embodiment of the invention.

One or more embodiments described herein utilise a transistor that is already present in a voltage regulator, such has an LDO voltage regulator, for connecting and disconnecting the voltage regulator to its load. An example of a load may be a voltage island in a systems-on-chip (SoC).

One or more embodiments described herein can avoid the need for a separate stand-by power switch (such as a further transistor) as the existing transistor in the voltage regulator can be used both as: i) a power switch for disconnecting the voltage regulator from the voltage island; and ii) perform its "normal" purpose as part of the LDO. Avoiding the need for an extra power switch transistor can reduce the total silicon area/real-estate required to implement a systems-on-chip (SoC) integrated circuit (IC), thereby providing for cost-efficient integration of power management functionality onto a chip.

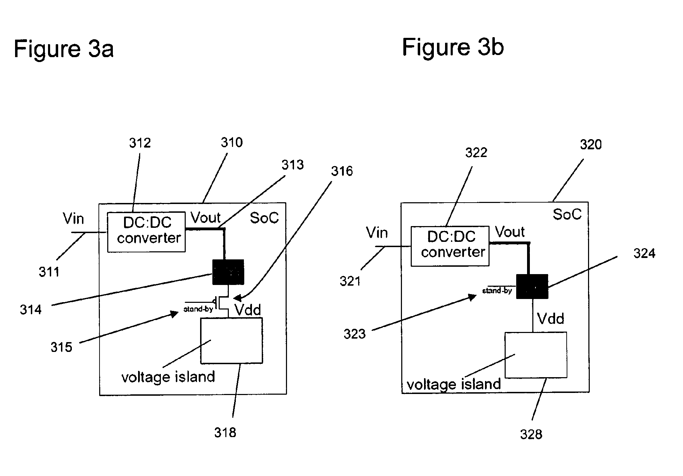

Figures 3a and 3b illustrate components of a systems-on-chip (SoC) according to the prior art (Figure 3a) and according to an embodiment of the invention (Figure 3b). Figure 3b illustrates a simplification in the SoC model of an embodiment of the invention when compared with Figure 3a.

This embodiment of the invention is based on the realisation that the large MOS transistors that are used in low dropout voltage regulators can be reused to perform the function of the power switches that activate and deactivate a voltage island or ay other type of load that can be supplied by the regulated voltage. The MOS transistors of the low dropout voltage regulators can be comparable in size with the power switches that are used to activate and deactivate a voltage island to which the low dropout voltage regulator is connected. That is, the large transistors that are typically used for the regulation of the LDO output voltage can also be re-used to perform the function of power switches.

Figure 3a illustrates an SoC 310 according to the prior art. The SoC 310 has an input to receive an input voltage 311, which is provided to a DC:DC converter 312. The DC:DC converter 312 is configured to convert the input voltage 311 into an output voltage Vout 313 that is an intermediate voltage to be supplied to one or more LDOs 314. An example prior art LDO is described and illustrated with reference to Figure 2 above.

The output of the LDO 314 is provided to the source of a transistor 316 acting as a power switch. A standby signal 315 is provided to the gate of the transistor 316 in order to control whether or not the output voltage of the LDO 314 is provided to a voltage island 318. That is, the state of the power switch 314 is controlled by the standby signal 315.

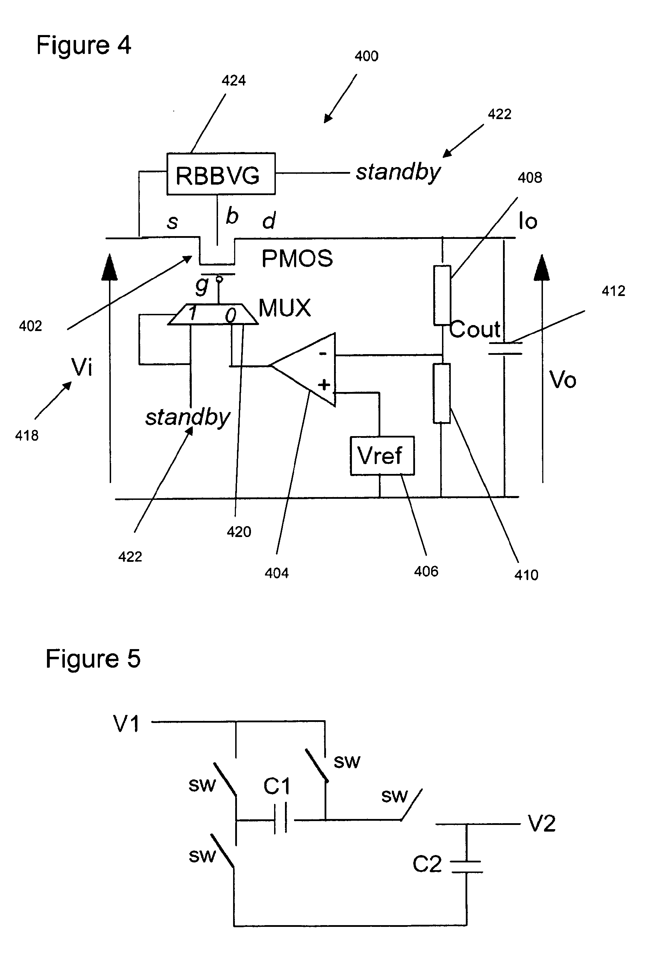

Figure 3b illustrates an SoC 320 according to an embodiment of the invention. The SoC 320 of Figure 3b is similar to the SoC 310 of Figure 3a, but does not include a separate transistor (identified as 316 in Figure 3a) for operably connecting or disconnecting the output of the LDO 324 to the voltage island 328. In this embodiment of the invention, a standby signal 323 is provided directly to the LDO 324 in order to utilise existing components of the LDO 324 for operably connecting and disconnecting the output of the LDO 324 to the voltage island 328. Operation of such an LDO 324 is described below with reference to Figure 4.

Figure 4 illustrates a voltage regulator 400 according to an embodiment of the invention. Those components of the voltage regulator of Figure 4 that are common to the prior art voltage regulator of Figure 2 are given similar reference numbers in the 400 series.

The PMOS power transistor 402 of Figure 4 is used as a series pass element in the voltage regulator 400 and is an example of a controllable component. The gate terminal of the PMOS power transistor 402 is the control terminal of the transistor 402. It will be appreciated that the series pass element 402 acts like a constant current source when the transistor 402 is in the saturation region, or as a resistor if the transistor 402 is in the linear region. When in the saturation, the drain (load) current lo of the transistor 402 is controlled by changing its gate-source voltage Vgs. In this way, under varying load conditions the LDO always provides the required current level. If the LDO input voltage Vi 418 decreases below a certain value, the series pass element 402 in the linear region limits the load current like a normal resistor. In this case, the Vgs voltage of the transistor is no longer regulated by the control loop, but is dependent on the input voltage Vi of the LDO.

According to this embodiment of the invention, instead of the output of the comparator 404 being connected directly to the gate of the transistor 402 (as in the prior art regulator of Figure 2), it is connected to the first input of a multiplexer 420. In this embodiment, the multiplexer 420 is a two-to-one multiplexer that can operably connect or disconnect the output of the comparator 404 to the gate of the transistor 402. The second input of the multiplexer is connected directly to a standby signal 422 of the voltage regulator 400.

It will be appreciated that the standby signal 422 comprises a signal representative of whether or not the voltage island to which the voltage regulator 408 is connected should be placed in a standby mode of operation.

The standby signal 422 is also directed to the signal selection input of the multiplexer 420. In this way, when the standby signal is high, the high signal that is provided as the select input to the multiplexer 420 causes the standby signal 420 to be passed to the output of the multiplexer 420. As the transistor is a PMOS FET, this causes the conductivity of the channel of the FET to be decreased, thereby preventing the input voltage 418 being passed to the output of the voltage regulator 400. Therefore, no (or very little) voltage is provided to a voltage island to which the output of the voltage regulator is connected.

It will be appreciated that the standby signal is an example of a control signal, and that the control signal that is directed to the input of the multiplexer need not necessarily be the same control signal as the control signal that is directed to the signal selection input of the multiplexer 420. For example, the control signal that is directed to the input of the multiplexer may be any signal that causes the transistor 402 (or any other controllable component) to disconnect the output of the voltage regulator from the input of the voltage regulator. The control signal that is directed to the signal selection input of the multiplexer 420 may be any signal that is representative of when the output of the voltage regulator should be disconnected from the input of the voltage regulator.

When a low standby signal 422 is received, and supplied as the select signal to the multiplexer 420, the multiplexer 420 is switched such that the output signal from the comparator 404 is provided to the gate of the FET 402. In this way, the conductivity of the channel between the source and the drain of the FET 402 is increased and an output voltage of the voltage regulator is provided for use by a voltage island.

In this embodiment, the standby signal that is connected to the second input of the multiplexer 420 is an example of a control signal that is connectable to the gate of the transistor 402 in order to effectively switch the transistor off. Although this is a convenient embodiment because the standby signal provides the desired signal level to switch the transistor 402 off when it is in the standby mode, it will be appreciated that any other control signal can be used that serves the purpose of switching the transistor off.

It will also be appreciated that the multiplexer 420 could be replaced with any other component/means for switching the transistor off. For example, one or more logic gates may be used to either directly or indirectly connect and disconnect the output of the voltage regulator to the input of the voltage regulator.

Advantages offered by the voltage regulator of Figure 4 can include a reduction in the total silicon area that is required to implement the systems-on-chip (SoC) with a voltage regulator. The power switches that are known in the prior art must be implemented with a very large transistor (a typical power switch is a PMOS transistor with the channel width of a few thousands micrometers) in order to deal with a large current (typically in the range of hundreds of mAs) that an LDO supplies to the associated voltage island. Large transistors can have smaller resistance when they are on, and therefore cause lower power losses. Even when special layout techniques are applied, the separate power switch increases the total SoC silicon area. Also, even if a voltage island is disconnected from its supply voltage, there is a leakage current flowing from the power supply to the power switch and consequently to the voltage island, and this can cause static power dissipation. The leakage current of the deactivated power switch may be substantial due to the large size of the switch. Embodiments of the invention can reduce the above-mentioned drawbacks as a separate power switch may not be required to activate and deactivate a voltage island. In some embodiments, the overall power consumption of a SoC can be reduced.

Returning to the voltage regulator 400 of Figure 4, a capacitor Cout 412 is connected between the outputs of the voltage regulator 400. When the standby signal is low, and the voltage regulator is providing an output voltage, the capacitor Cout 412 will charge. Similarly, when the standby signal is high, and the voltage regulator is not providing an output voltage, the capacitor Cout 412 will discharge to the voltage island. The current that is provided by the discharging of the capacitor Cout 412 can be used by one or more "watchdog" components/blocks of the voltage island. It will be appreciated that watchdog blocks consume a small amount of power in order to monitor for a signal representative of the fact that the voltage island should be switched on and taken out of standby mode. This is in contrast to when the voltage island should be switched off completely when no current should be supplied to the voltage island. It will be appreciated that there is a difference between switching a component/block/voltage island off, and placing it in standby.

One or more embodiments described herein can provide a voltage island with sufficient current (albeit a small amount in some embodiments) such that one or more watchdog components can operate correctly.

In some embodiments, control of the PMOS FET 402 can be controlled such that a small current is always provided to the voltage island by the capacitor Cout 412. For example, the voltage regulator may be configured such that upon a determination that the capacitor Cout 412 is completely discharged, the PMOS FET 402 is switched on for only a short period of time in order to re-charge the capacitor Cout 412. In this way, when the voltage regulator is in standby mode, the capacitor can always be provided with sufficient charge to be able to provide sufficient current to a watchdog component in a voltage island. It will be appreciated that the "short period of time" that the PMOS FET 402 is switched on for may be considered as a sufficient time to recharge the capacitor Cout 412 without using unnecessary power, and therefore unnecessarily detracting from the efficiency of the circuit/chip as a whole.

Providing the watchdog component with current in this way can be considered as advantageous over the prior art, where the watchdog components can be provided on a separate voltage island that is not switched off or placed in standby. Therefore, watchdog components according to the prior art always draw current, whereas operation of the voltage regulator according to an embodiment of the invention can enable a watchdog component to only draw additional current when the associated voltage island is in standby. Furthermore, the watchdog component may only draw additional current from a battery for a short period of time when the capacitor of the voltage regulator is completely discharged.

Embodiments of the voltage regulator described herein can enable watchdog components to be supplied with current in a new way. Prior art watchdog implementations can either: i) be provided as a dedicated block (usually, a part of a specialized power management IC); or ii) be provided as built-in watchdogs (for example, as part of a microcontroller, processor, or any digital IP block).

Where watchdog components are provided as built-in watchdogs, the watchdog circuitry is always supplied with a nominal voltage level as it must run irrespective of the mode of operation of the rest of the block/voltage island. That is, even if the rest of the system/block can enter a standby mode, the watchdog components still need to be provided with current. Typically, this is implemented by placing the watchdog circuitry on a different voltage island or supplying it within an island from a different dedicated voltage supply pin that is connected to a nominal supply voltage level whereas the rest of the block is supplied from a lowered supply voltage from an LDO for example.

It will be appreciated that embodiments of the invention provide advantages over the prior art in that a nominal supply voltage for the watchdog circuitry is not required. This can enable the overall efficiency of an integrated circuit (IC), such as a SoC, to be improved.

Also illustrated in Figure 4 is an optional reverse body-bias voltage generation (RBBVG) module 424. The RBBVG module 424 utilises the bulk terminal of the PMOS FET 402 to reduce the leakage current of the FET 402 when the voltage regulator 400 is in standby mode.

When the voltage regulator 400 is not in standby mode, as determined by the standby input signal 422, the RBBVG module 424 connects the bulk terminal of the FET 402 to the source of the FET 402. The source of the FET is also connected to the input voltage of the voltage regulator 400. When the standby signal 422 goes high, the RBBVG module 424 provides a voltage at the bulk terminal of the FET 402, such that the bulk terminal voltage is higher than the input voltage at the source of the FET 402, consequently increasing $V_{bs}$ voltage. In this way, the threshold voltage of the FET 402 is increased and the leakage current is reduced in accordance with the following formula:

$$V_T = V_{To} + \gamma \cdot ( \sqrt{2|\phi_F| - V_{bs}} - \sqrt{2|\phi_F|} )$$

The threshold voltage will be negative for PMOS transistors and will be positive for NMOS transistors.

It will be appreciated that reverse body-biasing can be applied to the power transistor 402 of the LDO 400 to reduce the leakage current of this large transistor 402 in the standby mode. This can provide a: reduction of the leakage power consumption of the whole system.

The bias voltage to be supplied to the bulk terminal of the FET 402 by the RBBVG module 424 when in standby mode can be generated by a dedicated circuit. This is because the reverse body-bias voltage level should be higher than the voltage level at the source terminal of the transistor. An example of such circuitry is shown as Figure 5, which illustrates a voltage doubler that can be used with embodiments of the invention for LDOs using a PMOS FET as a series-pass element.

The embodiment of Figure 5 comprises a switched-capacitor converter, as is known in the art, to provide an output voltage V2 that is double the input voltage V1. It will be appreciated that sequential operation of the switches can be controlled in order to provide the desired output voltage.

The silicon area/real-estate of an integrated circuit (IC) required for the RBBVG module can be very small because the current drawn by the RBBVG module can also be very small. For example, for a CMOS065 process, the RBBVG module may only require a current of the order of nano amps. In one embodiment, only 0.02 mm$^2$ of silicon area is required to provide an RBBVG module with 90% efficiency, a switching frequency of about 100 MHz, a current of 100 mA and 1% output voltage ripple. This implementation may utilise on-chip capacitors (C1 and C2).

It will be appreciated by the skilled person that alternative types of transistor to the PMOS power transistor 402 can be used according to different embodiments of the invention. For example an NMOS transistor or a bipolar junction transistor could be used. It will be readily appreciated how the terminals of the different types of transistors can be incorporated into a similar circuit to that shown in Figure 4 in order to achieve the desired performance. In some examples, use of a bipolar junction transistor may be particularly advantageous for discrete implementations of the invention.

In further embodiments still, the transistor may be replaced by any controllable component/element that can serve the purpose of connecting and disconnecting the output and the input of the voltage regulator. For example, a variable resistor may be incorporated into the voltage regulator, possibly in place of the transistor, wherein the resistance of the variable resistor can be set as a high value when the output of the voltage regulator is to be disconnected from the input of the voltage regulator. Similarly, the resistance of the variable resistor can be set as a low value when the output of the voltage regulator is to be connected from the input of the voltage regulator.

An example of a "high value" of the variable resistor is of the order of Mega-Ohm's, and an example of a low value of the variable resistor is of the order of milli-Ohm's. It will be appreciated that the invention is not limited to specific values for the resistance of the variable resistor, and that any values can be used that effectively cause the input and output of the voltage regulator to be connectable and disconnectable with/from each other.

One or more embodiments described herein can be well suited for highly-integrated SoCs in which power consumption reduction is very important. Power consumption can be an important requirement for integrated circuits in portable electronic applications, such as mobile phones, personal digital assistants (PDAs), portable music players such as MP3 players, etc.

Embodiments described herein may be especially useful for electronic devices that use dynamic or adaptive voltage scaling.

Embodiments described herein can provide area-efficient voltage regulation components and can be more easily integrated into existing circuits. For example, embodiments described herein can utilise integrated LDOs that are responsible for the conversion of a first voltage level (for example as derived from a battery voltage source) to the voltage levels required by independent voltage islands.

It will be appreciated that although embodiments of the invention have been described in relation to an integrated solution, discrete implementations of the inventions can also be provided.

In contrast to known implementations, embodiments of the invention can enable power switches that are typically used for disconnecting voltage islands from their supplies in the stand-by mode to be removed. The function of the power switches can be incorporated by the power transistors already present in LDOs. This may be known as the re-use concept. Additionally, in some embodiments, the leakage current of the LDO power transistors can be reduced by applying reverse body-biasing to these transistors. Also, the discharge current of the output capacitor of an LDO can be used to supply the watchdog functions of a voltage island with a small current when the voltage island enters the standby mode. In this way, the state of the voltage island can be preserved such that the process of leaving the standby mode can be sped up and/or performed more efficiently.

**Claims**

1. A voltage regulator (400) comprising:

   a controllable component (402) connected between the input and output of the voltage regulator,

   wherein the controllable component (402) is configured to connect and disconnect the output of the voltage regulator (400) to the input of the voltage regulator (400) in accordance with a received control signal (422).

2. The voltage regulator (400) of claim 1, wherein the controllable component is a transistor (402).

3. The voltage regulator (400) of claim 1 or claim 2, wherein the controllable component (402) is configured to break a control loop of the voltage regulator when disconnecting the output of the voltage regulator (400) from the input of the voltage regulator (400).

**4.** The voltage regulator (400) of claim 2 or claim 3, wherein the voltage regulator (400) comprises an amplifier (404), and the output of the amplifier (404) is connectable and disconnectable to a control terminal of the transistor (402) in accordance with the received control signal (422).

**5.** The voltage regulator (400) of claim 4, further comprising a multiplexer (420) configured to connect either the output of the amplifier (404) or a second control signal to the transistor (402) in accordance with the control signal (422).

**6.** The voltage regulator (400) of claim 5, wherein the second control signal is the same as the control signal (422).

**7.** The voltage regulator (400) of any one of claims 4 to 6, wherein the amplifier (404) has a positive input and a negative input, and the positive input is connected to a constant voltage reference source (406), and the negative input is connected to a proportion of the output voltage as determined by the values of a resistor pair (408, 410).

**8.** The voltage regulator (400) of any preceding claim, further comprising a capacitor (412) connected across the output of the voltage regulator (400), wherein the capacitor (412) is configured to discharge when the output of the amplifier (404) is not connected to the transistor (402) such that the capacitor provides an output current when the voltage regulator is switched off.

**9.** The voltage regulator (400) of claim 8, wherein the output current of the capacitor (412) is provided to a watchdog component associated with a voltage island.

**10.** The voltage regulator (400) of claim 8 or claim 9, wherein the output of the amplifier (404) is connectable to the transistor (402) if the control signal is representative of a standby state and the capacitor (412) is discharged.

**11.** The voltage regulator (400) of any preceding claim, further comprising a "reverse body-bias voltage generation" module (424) configured to:

when the standby signal (422) is high, provide the bulk terminal of the transistor (402) with a voltage that is higher than the input voltage in order to reduce the leakage current of the transistor (402); and
when the standby signal (422) is low, connect the bulk terminal of the transistor (402) to the input voltage.

**12.** The voltage regulator (400) of claim 11, wherein the "reverse body-bias voltage generation" module (424) comprises a voltage multiplier configured to generate an output voltage that is higher than its input voltage.

**13.** An integrated circuit comprising the voltage regulator of any preceding claim.

**14.** An electronic device comprising the voltage regulator of any one of claims 1 to 12, or an integrated circuit according to claim 13.

**15.** A method of operating a voltage regulator (400), the voltage regulator (400) comprising:

a controllable element (402) connected between the input and output of the voltage regulator (400);

the method comprising:

receiving a control signal (422); and
automatically connecting or disconnecting the output of the voltage regulator (400) to the input of the voltage regulator (400) in accordance with the received control signal.

## Figure 1

## Figure 2

## Figure 3a

## Figure 3b

Figure 4

Figure 5

Europäisches
Patentamt
European
Patent Office
Office européen
des brevets

## EUROPEAN SEARCH REPORT

**Application Number**

EP 09 25 1598

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/108993 A1 (CHIEN HUNG J [TW] ET AL CHIEN HUNG JEN [TW] ET AL) 25 May 2006 (2006-05-25) * the whole document * | 1-15 | INV. G05F1/565 |
| A | US 2007/262810 A1 (LEE CHAO-CHENG [TW] ET AL) 15 November 2007 (2007-11-15) * abstract; figure 1 * | 1-15 | |
| A | US 7 495 506 B1 (CARPER SCOTT D [US]) 24 February 2009 (2009-02-24) * abstract; figures 1-3 * | 1-15 | |
| A | PH D JOSE MIGUEL DE DIEGO ET AL: "Improvements of Power Supply Systems in Machine to Machine Modules and Fixed Cellular Terminals with Discontinuous Current Consumption" INDUSTRIAL TECHNOLOGY, 2006. ICIT 2006. IEEE INTERNATIONAL CONFERENCE ON, IEEE, PI, 1 December 2006 (2006-12-01), pages 2575-2580, XP031178172 ISBN: 978-1-4244-0725-5 * the whole document * | 1-15 | TECHNICAL FIELDS SEARCHED (IPC) G05F |

The present search report has been drawn up for all claims

| Place of search | Date of completion of the search | Examiner |
|---|---|---|
| The Hague | 21 October 2009 | Arias Pérez, Jagoba |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 09 25 1598

This annex lists the patent family members relating to the patent documents cited in the above-mentioned European search report.
The members are as contained in the European Patent Office EDP file on
The European Patent Office is in no way liable for these particulars which are merely given for the purpose of information.

21-10-2009

| Patent document cited in search report | | Publication date | Patent family member(s) | Publication date |
|---|---|---|---|---|
| US 2006108993 | A1 | 25-05-2006 | TW      263124 B | 01-10-2006 |
| US 2007262810 | A1 | 15-11-2007 | DE 102007021975 A1 | 24-01-2008 |
| US 7495506 | B1 | 24-02-2009 | NONE | |

EPO FORM P0459

For more details about this annex : see Official Journal of the European Patent Office, No. 12/82